(19)

Europäisches
Patentamt

European
Patent Office

Office européen
des brevets

(11) **EP 4 700 818 A1**

(12) **EUROPEAN PATENT APPLICATION**

(43) Date of publication:
**25.02.2026 Bulletin 2026/09**

(21) Application number: **25196842.6**

(22) Date of filing: **19.08.2025**

(51) International Patent Classification (IPC):
*H01H 47/00* (2006.01)  *G01R 31/00* (2006.01)
*G01R 31/327* (2006.01)

(52) Cooperative Patent Classification (CPC):
**H01H 47/002; B60L 3/0023; B60L 3/0046;
B60L 3/04; B60L 3/12; B60L 15/2054; B60L 50/51;
B60L 58/12; B60L 58/16; B60L 58/19; B60L 58/21;
B60L 58/22; B64D 27/33; B64D 27/357;
G01R 31/008;** (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **19.08.2024   US 202418809161**

(71) Applicant: **PRATT & WHITNEY CANADA CORP.
Longueuil, Québec J4G 1A1 (CA)**

(72) Inventors:
• SHENOUDA, Antwan
  (01BE5) Longueuil, J4G 1A1 (CA)
• LAM, Simon
  (01BE5) Longueuil, J4G 1A1 (CA)
• KHARAL, Fraz
  (01BE5) Longueuil, J4G 1A1 (CA)
• GARIEPY, Raphael
  (01BE5) Longueuil, J4G 1A1 (CA)
• ROBACHE, Remi
  (01BE5) Longueuil, J4G 1A1 (CA)

(74) Representative: **Dehns
10 Old Bailey
London EC4M 7NG (GB)**

(54) **PROPULSION SYSTEM FOR AN AIRCRAFT AND METHOD IDENTIFYING AN END-OF-LIFE
CONDITION FOR AN ELECTRICAL CONTACTOR**

(57)    A propulsion system includes an electrical assembly (24) and a controller (68). The electrical assembly includes at least one contactor (84) and a sensor assembly (98,100). The at least one contactor (84) is switchable by a switching operation between an open condition and a closed condition. The controller (68) is connected in signal communication with the sensor assembly (98,100). The controller (68) is configured to determine, using the sensor assembly (98,100), an electrical energy of the at least one contactor (84) for each switching operation of the at least one contactor (84) to determine a cumulative electrical energy for the at least one contactor (84) and identify a presence or an absence of an end-of-life condition for the at least one contactor (84) by comparing the cumulative electrical energy to an end-of-life energy threshold. The presence of the end-of-life condition is identified where the cumulative electric energy exceeds the end-of-life energy threshold.

FIG. 4

**(Cont. next page)**

(52) Cooperative Patent Classification (CPC): (Cont.)
**G01R 31/3278;** B60L 2200/10; B60L 2210/30;
B60L 2210/40; B60L 2240/421; B60L 2240/423;
B60L 2240/545; B60L 2240/547; B60L 2240/549;
B64D 2045/0085; B64D 2221/00; H02J 2105/32

## Description

TECHNICAL FIELD

This invention relates generally to aircraft propulsion systems and, more particularly, to systems and methods for identifying an end-of-life condition for an electrical contactor of an aircraft propulsion system.

BACKGROUND OF THE ART

Propulsion system architectures for aircraft, such as hybrid-electric propulsion systems, may typically include one or more electrical assemblies configured to support various functions of the propulsion system and an associated aircraft. These electrical assemblies may include electrical contactors configured for selectively energizing or deenergizing components of the electrical assembly. Various systems and methods for identifying contactor wear are known. While these known systems and methods may be suitable for their intended purposes, there is always room in the art for improvement.

SUMMARY

It should be understood that any or all of the features or embodiments described herein can be used or combined in any combination with each and every other feature or embodiment described herein unless expressly noted otherwise.

According to an aspect of the present invention, a propulsion system for an aircraft includes an electrical assembly and a controller. The electrical assembly includes at least one contactor and a sensor assembly. The at least one contactor is switchable by a switching operation between an open condition and a closed condition. The controller is connected in signal communication with the sensor assembly. The controller includes a processor connected in signal communication with a non-transitory memory storing instructions which, when executed by the processor, cause the processor to determine, using the sensor assembly, an electrical energy of the at least one contactor for each switching operation of the at least one contactor to determine a cumulative electrical energy for the at least one contactor and identify a presence or an absence of an end-of-life condition for the at least one contactor by comparing the cumulative electrical energy to an end-of-life energy threshold. The presence of the end-of-life condition is identified where the cumulative electric energy exceeds the end-of-life energy threshold.

In any of the aspects or embodiments described above and herein, the instructions, when executed by the processor, may further cause the processor to measure a switching time of the switching operation for each switching operation of the at least one contactor and identify the presence or the absence of an end-of-life condition by comparing the switching time for each switching operation to a switching time threshold. The presence of the end-of-life condition may be identified where the cumulative electric energy exceeds the end-of-life energy threshold or the switching time exceeds the switching time threshold.

In any of the aspects or embodiments described above and herein, the switching time threshold may have a first switching time value for the switching operation from the open condition to the closed condition. The switching time threshold may have a second switching time value for the switching operation from the closed condition to the open condition. The first switching time value may be different than the second switching time value.

In any of the aspects or embodiments described above and herein, the instructions, when executed by the processor, may further cause the processor to measure a switching time of the switching operation for each switching operation of the at least one contactor and identify the presence or the absence of an end-of-life condition by comparing the switching time for each switching operation to a switching time threshold. The presence of the end-of-life condition may be identified where the cumulative electric energy exceeds the end-of-life energy threshold and the switching time exceeds the switching time threshold.

In any of the aspects or embodiments described above and herein, the instructions, when executed by the processor, may further cause the processor to measure a switching time of the switching operation for each switching operation of the at least one contactor and determine the electrical energy of the at least one contactor for each switching operation of the at least one contactor using the switching time of the switching operation for each switching operation of the at least one contactor.

In any of the aspects or embodiments described above and herein, the instructions, when executed by the processor, may further cause the processor to determine a switching time of the switching operation for each switching operation of the at least one contactor, determine a current and a voltage of the at least one contactor over the switching time for each switching operation of the at least one contactor, and determine the electrical energy of the at least one contactor for each switching operation using the switching time, the current, and the voltage.

In any of the aspects or embodiments described above and herein, the switching time may be a predetermined switching time value for the at least one contactor.

In any of the aspects or embodiments described above and herein, the instructions, when executed by the processor, may further cause the processor to determine a switching time of the switching operation for each switching operation of the at least one contactor, determine a current of the at least one contactor over the switching time for each switching operation of the at least one contactor, and determine the electrical energy of the at least one contactor for each switching operation using the switching time, the current, and a resistance of the at least one contactor.

In any of the aspects or embodiments described above and herein, the instructions, when executed by the processor, may further cause the processor to generate a maintenance message in response to identifying the presence of the end-of-life condition for the at least one contactor.

According to another aspect of the present invention, a method for identifying an end-of-life condition for a contactor of an aircraft propulsion system includes performing at least one switching operation to switch the contactor between an open condition and a closed condition, determining, for each switching operation of the at least one switching operation, an electrical energy of the contactor to determine a cumulative electrical energy for the contactor, the cumulative electrical energy including the electrical energy for each switching operation of the at least one switching operation, and identifying a presence or an absence of an end-of-life condition for the contactor by comparing the cumulative electrical energy to an end-of-life energy threshold.

In any of the aspects or embodiments described above and herein, the method may further include replacing the contactor in response to identifying the presence of the end-of-life condition for the contactor.

In any of the aspects or embodiments described above and herein, the presence of the end-of-life condition may be identified where the cumulative electrical energy is greater than the end-of-life energy threshold and the absence of the end-of-life condition may be identified where the cumulative electrical energy is less than the end-of-life energy threshold.

In any of the aspects or embodiments described above and herein, the method may further include measuring a switching time of the contactor for each of the at least one switching operation. Identifying the presence or the absence of the end-of-life condition for the contactor further may include comparing the switching time of the contactor for each of the at least one switching operation to a switching time threshold.

In any of the aspects or embodiments described above and herein, the method may further include determining a switching time of the at least one switching operation for each of the at least one switching operation, determining a current and a voltage of the contactor over the switching time for each of the at least one switching operation, and determining the electrical energy of the contactor for each of the at least one switching operation using the switching time, the current, and the voltage.

In any of the aspects or embodiments described above and herein, the switching time may be a predetermined switching time value for the contactor.

According to another aspect of the present invention, a method for identifying an end-of-life condition for a contactor of an aircraft propulsion system includes performing at least one switching operation to switch the contactor between an open condition and a closed condition and determining, for each switching operation of the at least one switching operation, a switching time of the contactor between the open condition and the closed condition and an electrical energy of the contactor over the switching time to determine a cumulative electrical energy for the contactor. The cumulative electrical energy includes the electrical energy for each switching operation of the at least one switching operation. The method further includes identifying a presence or an absence of an end-of-life condition for the contactor, for each of the at least one switching operations, by comparing the cumulative electrical energy to an end-of-life energy threshold and by comparing the switching time to a switching time threshold. The presence of the end-of-life condition for the contactor is identified where one or both of the cumulative electrical energy exceeds the end-of-life energy threshold or the switching time exceeds the switching time threshold.

In any of the aspects or embodiments described above and herein, the switching time threshold may have a first switching time value for each of the at least one switching operation from the open condition to the closed condition, the switching time threshold may have a second switching time value for each of the at least switching operation from the closed condition to the open condition, and the first switching time value may be different than the second switching time value.

In any of the aspects or embodiments described above and herein, the method may further include generating a maintenance message in response to identifying the presence of the end-of-life condition for the contactor.

In any of the aspects or embodiments described above and herein, determining the electrical energy of the contactor over the switching time may include determining a current and a voltage of the contactor over the switching time and calculating the electrical energy using the switching time, the current, and the voltage.

In any of the aspects or embodiments described above and herein, determining the electrical energy of the contactor over the switching time may include determining a current of the contactor over the switching time and calculating the electrical energy using the switching time, the current, and a resistance of the contactor.

The present invention, and all its aspects, embodiments and advantages associated therewith will become more readily apparent in view of the detailed description provided below, including the accompanying drawings.

DESCRIPTION OF THE DRAWINGS

FIG. 1 illustrates an aircraft including a propulsion system, in accordance with one or more embodiments of the present invention.

FIG. 2 schematically illustrates a cutaway, side view of an aircraft propulsion system, in accordance with one or more embodiments of the present invention.

FIG. 3 schematically illustrates a battery string for a battery, in accordance with one or more embodiments of the present invention.

FIG. 4 schematically illustrates an electrical assembly for an aircraft propulsion system, in accordance with one or more embodiments of the present invention.

FIG. 5 illustrates a block diagram depicting a method identifying an end-of-life condition for an electrical contactor, in accordance with one or more embodiments of the present invention.

DETAILED DESCRIPTION

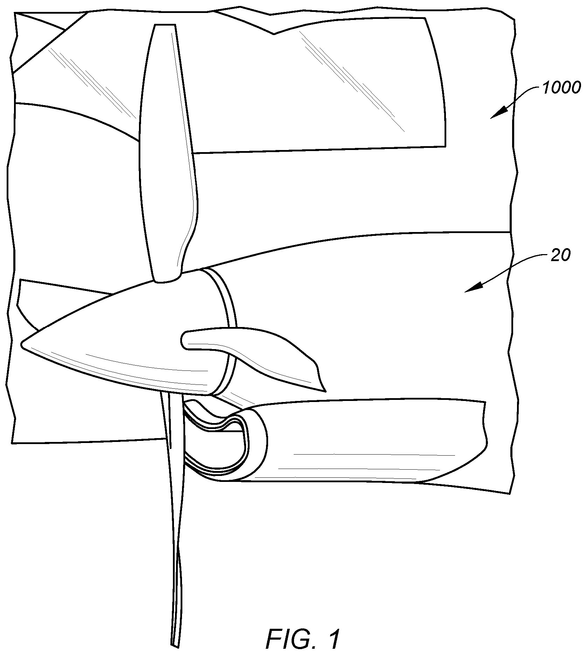

FIG. 1 illustrates an aircraft 1000 including at least one propulsion system 20. Briefly, the aircraft may be a fixed-wing aircraft (e.g., an airplane), a rotary-wing aircraft (e.g., a helicopter), a tilt-rotor aircraft, a tilt-wing aircraft, or another aerial vehicle. Moreover, the aircraft may be a manned aerial vehicle or an unmanned aerial vehicle (UAV, e.g., a drone).

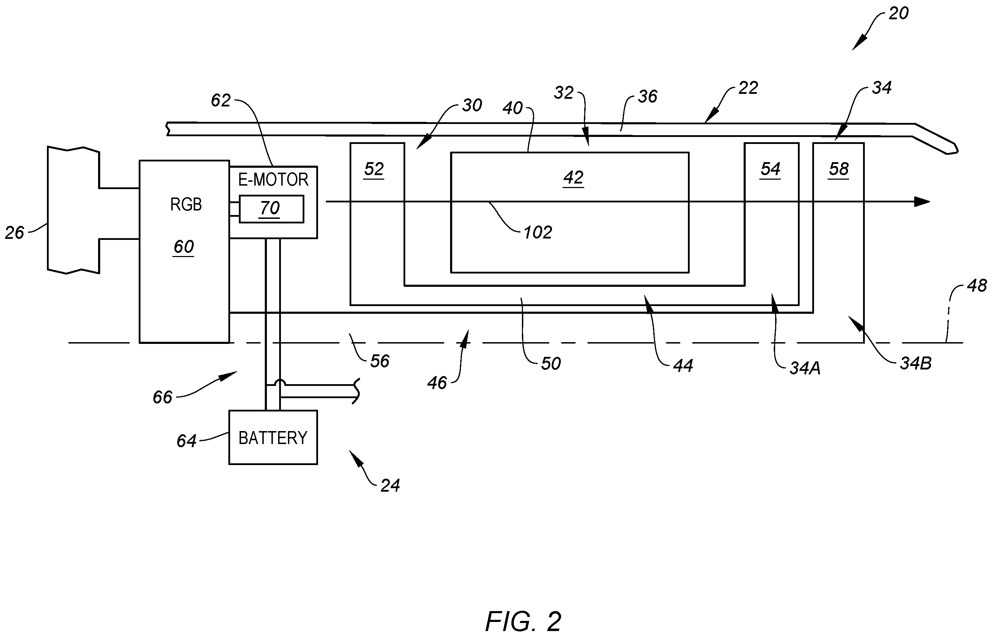

FIG. 2 schematically illustrates a cutaway, side view of the propulsion system 20. The propulsion system 20 of FIG. 2 includes an engine 22, an electrical assembly 24, and a propulsor 26. The engine 22 of FIG. 2 is configured as a turboprop gas turbine engine. However, the present invention is not limited to any particular configuration of gas turbine engine for the propulsion system 20, and examples of gas turbine engine configurations for the propulsion system 20 may include, but are not limited to, a turbofan engine, a turbojet engine, a propfan engine, or the like. Moreover, the present invention is not limited to propulsion systems including a gas turbine engine. For example, the engine 22 may alternatively be configured as an intermittent combustion engine such as, but not limited to, a rotary engine (e.g., a Wankel engine), a piston engine, or the like.

The engine 22 of FIG. 2 includes a compressor section 30, a combustor section 32, a turbine section 34, and an engine static structure 36. The combustor section 32 includes a combustor 40 (e.g., an annular combustor). The combustor 40 forms a combustion chamber 42. The turbine section 34 includes a high-pressure turbine section 34A and a power turbine section 34B.

Components of the compressor section 30 and the turbine section 34 of FIG. 2 form a first rotational assembly 44 (e.g., a high-pressure spool) and a second rotational assembly 46 of the engine 22. The first rotational assembly 44 and the second rotational assembly 46 are mounted for rotation about a rotational axis 48 (e.g., an axial centerline) of the engine 22 relative to the engine static structure 36.

The first rotational assembly 44 includes a first shaft 50, a bladed compressor rotor 52 for the compressor section 30, and a bladed first turbine rotor 54 for the high-pressure turbine section 34A. The first shaft 50 interconnects the bladed compressor rotor 52 and the bladed first turbine rotor 54.

The second rotational assembly 46 of FIG. 2 includes a second shaft 56 and a bladed second turbine rotor 58 for the power turbine section 34B. The second shaft 56 is connected to the bladed second turbine rotor 58. The second shaft 56 operably connects (e.g., directly or indirectly connects) the bladed second turbine rotor 58 with the propulsor 26. For example, the second shaft 56 of FIG. 2 is coupled with the propulsor 26 by a gear box 60 (e.g., a reduction gear box (RGB)). The gear box 60 includes a gear assembly (e.g., an epicyclic gear assembly) coupling the second shaft 56 and the propulsor 26. The gear assembly may be a reduction gear assembly configured to drive rotation of the propulsor 26 at a reduced rotational speed relative to the second shaft 56. Of course, the second shaft 56 may alternatively be directly connected to the propulsor 26 to drive the propulsor 26 at the same rotational speed as the second shaft 56.

The engine static structure 36 includes engine casings, cowlings, and other fixed (e.g., non-rotating) structures of the engine 22 which house and/or support components of the engine 22 such as, but not limited to, those of the compressor section 30, the combustor section 32, and the turbine section 34. The engine static structure 36 includes one or more bearing assemblies and/or gear trains configured to rotationally support and/or interconnect components of the first rotational assembly 44 and the second rotational assembly 46.

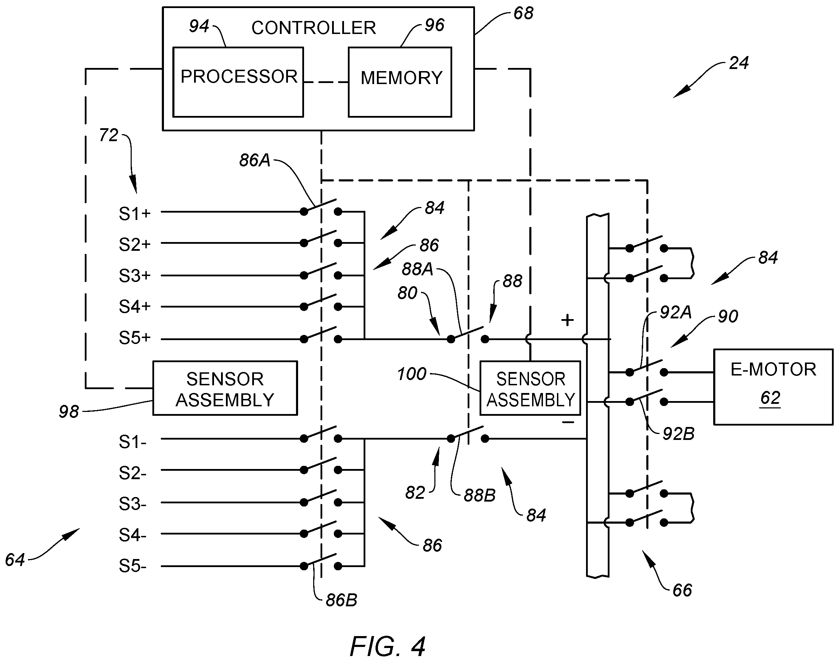

The electrical assembly 24 of FIG. 2 includes an electric motor 62, a battery 64, an electrical distribution system 66, and a controller 68 (not shown in FIG. 2; see FIG. 4).

The electric motor 62 is electrically connected to the electrical distribution system 66. The electric motor 62 includes a rotor 70. The rotor 70 is coupled to the propulsor 26 by the gear box 60. For example, the gear box 60 may couple both of the second shaft 56 and the rotor 70 to the propulsor 26 to facilitate driving rotation of the propulsor 26 with the bladed second turbine rotor 58 (e.g., via the second shaft 56), the electric motor 62 (e.g., the rotor 70), or a combination of the bladed second turbine rotor 58 and the electric motor 62. The electric motor 62 may additionally include a motor control unit (e.g., an inverter) configured to control electric power characteristics (e.g., frequency, voltage, current) supplied to the electric motor 62 (e.g., windings of the electric motor 62), for example, to control a rotation speed and/or torque of the rotor 70.

The battery 64 is electrically connected to the electrical distribution system 66. The battery 64 is configured to selectively supply electrical power to the electrical distribution system 66 independently (e.g., as a single power source for the electrical assembly 24) or in combination with one or more other electrical power sources (e.g., an electrical generator). The battery 64 may include a plurality of battery modules (e.g., battery packs), battery cells, and/or the like electrically connected together in series and/or parallel as necessary to configure the battery 64 with the desired electrical characteristics (e.g., voltage output, current output, storage capacity, etc.). The present invention is not limited to any particular configuration of the battery 64. The battery 64 (e.g., and its battery cells) may be configured as a rechargeable battery having a battery chemistry such as, but not limited to, lead acid, nickel cadmium (NiCd), nickel-metal hydride (Ni-MH), lithium-ion (Li-ion), lithium-polymer (Li-poly), lithium metal, and the like. The battery 64 may be disposed, for example, in the aircraft 1000 and/or its propulsion system 20.

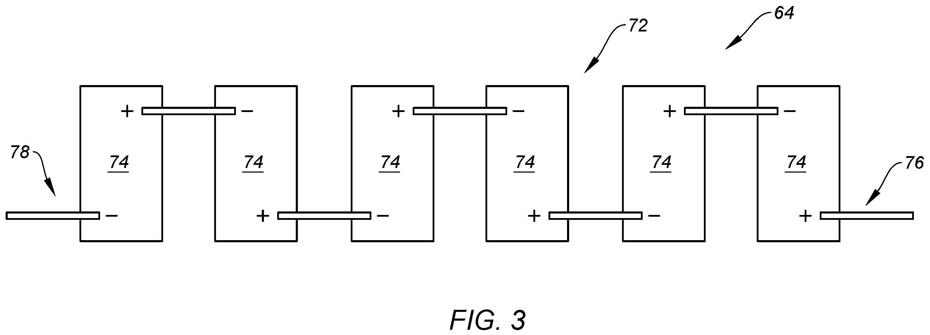

FIG. 3 schematically illustrates an exemplary battery string 72 of the battery 64. The battery string 72 of FIG. 3 includes a plurality of battery modules 74 (e.g., battery packs electrically connected in series to form the battery string 72. For example, each battery modules 74 of the battery string 72 may be electrically connected in series (e.g., positive to negative or negative to positive) to one or more other battery modules 74 of the battery string 72. The battery string 72 includes a positive string terminal 76 and a negative string terminal 78 for connecting the battery string 72 in electrical communication with other components of the battery 64 and/or the electrical distribution system 66. The battery string 72 of FIG. 3 includes six (6) battery modules 74 electrically connected in series. The present invention, however, is not limited to any particular number of battery modules 74 for the battery string 72. Each battery module 74 may include a plurality of discrete battery cells electrically connected together (e.g., using series and/or parallel electrical connections) to form the battery module 74, and as necessary to configure the battery string 72 with the desired electrical characteristics (e.g., voltage output, power output, etc.) for the battery 64.

FIG. 4 schematically illustrates a portion of the electrical assembly 24 including the battery 64 and the electrical distribution system 66. The battery 64 of FIG. 4 includes a plurality of the battery strings 72 electrically connected together in parallel. For example, the plurality of battery strings 72 of FIG. 4 includes five (5) battery strings 72, S1-5 with their positive string terminals 76 (e.g., S1+, S2+, S3+, S4+, S5+) electrically connected together at a positive battery terminal 80 of the battery 64 and their negative string terminals 78 (e.g., S1-, S2-, S3-, S4-, S5-) electrically connected together at a negative battery terminal 82 of the battery 64.

The electrical distribution system 66 electrically interconnects components of the electrical assembly 24. The electrical distribution system 66 includes switchgear, cables, wires, breakers, switches, contactors, electrical power conditional and/or conversion (e.g., AC to DC or DC to AC conversion) components, and/or other electrical components to effect the transfer of electrical power between components of the electrical assembly 24. For example, the electrical distribution system 66 of FIG. 2 electrically connects the electric motor 62 (and other electrical loads of the aircraft 1000 and/or the propulsion system 20) with the battery 64 and other electric power sources (e.g., an electrical generator) of the electrical assembly 24. The electrical distribution system 66 may additionally include one or more electrical power controllers, for example, to control a magnitude and/or direction of electrical current flow to components of the electrical assembly 24. The electrical distribution system 66 is configured to supply electrical power to electrical loads of the aircraft 1000, the propulsion system 20, and/or the engine 22.

The electrical assembly 24 includes a plurality of electrical contactors 84. The contactors 84 are configured to facilitate selective control of electrical current flow through the electrical assembly 24 and its components including, but not limited to, the electric motor 62, the battery 64, and the electrical distribution system 66. The contactors 84 are selectively configurable (e.g., switchable) in and between a closed condition or an open condition to conduct or interrupt an electrical current flow, respectively. The contactors 84 may include electrically-controlled relays or switches which may be controlled by an electrical control signal to position the respective contactors 84 in open condition or the closed condition. The contactors 84 of FIG. 4 include string contactors 86, battery contactors 88, and load contactors 90. Of course, the present invention is not limited to the foregoing exemplary categories of electrical contactors.

Each of the battery strings 72 of FIG. 4 includes a positive string contactor 86A and a negative string contactor 86B. The positive string contactor 86A is electrically connected with each respective one of the battery strings 72 at the positive string terminal 76. The negative battery contactor 88B is electrically connected with each respective one of the battery strings 72 at the negative string terminal 78. Each of the positive string contactor 86A and the negative string contactor 86B is respectively switchable between the closed condition and the open condition to conduct or interrupt electrical current flow therethrough. For example, the positive string contactor 86A and the negative string contactor 86B for one of the battery strings 72, S1-5 may be in the closed condition to electrically connect the respective battery string 72, S1-5 to the electrical distribution system 66 or may be in the open condition to electrically isolate the respective battery string 72, S1-5 from the electrical distribution system 66. While each of the battery strings 72 of FIG. 4 includes both the positive string contactor 86A and the negative string contactor 86B, the present invention is not limited to the use of both the positive string contactor 86A and the negative string contactor 86B for each of the battery strings 72 (e.g., the battery strings 72 may include the positive string contactor 86A or the negative string contactor 86B).

The battery contactors 88 of FIG. 4 include a positive battery contactor 88A and a negative battery contactor 88B. The positive battery contactor 88A is electrically connected between the battery strings 72 (e.g., the positive string terminal 76) and the electrical distribution system 66. The negative battery contactor 88B is electrically connected between the battery strings 72 (e.g., the negative string terminal 78) and the electrical distribution system 66. Each of the positive battery contactor 88A and the negative battery contactor 88B is respectively switchable between the closed condition and the open condition to conduct or interrupt electrical current flow therethrough. For example, the positive battery contactor 88A and the negative battery contactor 88B for the battery 64 may be in the closed condition to electrically connect the battery 64 to the electrical distribution system 66 or may be in the open condition to electrically isolate the battery 64 from the electrical distribution system 66. While the battery 64 of FIG. 4 includes both the positive battery contactor 88A and the negative battery contactor 88B, the present invention is not limited to the use of both the positive battery contactor 88A and the battery contactor 88B (e.g., the battery 64 may include the positive battery contactor 88A or the negative battery contactor 88B).

The load contactors 90 may include a positive load contactor 90A and a negative load contactor 90B for one or more electrical loads of the aircraft 1000 and/or its propulsion system 20. Each of the positive load contactor 90A and the negative load contactor 90B is respectively switchable between the closed condition and the open condition to conduct or interrupt electrical current flow therethrough. The positive load contactor 90A and the negative load contactor 90B for a respective electrical load may be in the closed condition to electrically connect the electrical load to the electrical distribution system 66 or may be in the open condition to electrically isolate the electrical load from the electrical distribution system 66. For example, the load contactors 90 may include a positive motor contactor 92A and a negative motor contactor 92B for the electric motor 62.

The controller 68 includes a processor 94 connected in signal communication with memory 96. The processor 94 may include any type of computing device, computational circuit, processor(s), central processing unit (CPU), graphics processing unit (GPU), computer, or the like capable of executing a series of instructions that are stored in memory 96. Instructions can be directly executable or can be used to develop executable instructions. For example, instructions can be realized as executable or non-executable machine code or as instructions in a high-level language that can be compiled to produce executable or non-executable machine code. Further, instructions also can be realized as or can include data. Computer-executable instructions also can be organized in any format, including routines, subroutines, programs, data structures, objects, modules, applications, applets, functions, etc. The instructions may include an operating system, and/or executable software modules such as program files, system data, buffers, drivers, utilities, and the like. The executable instructions may apply to any functionality described herein to enable the controller 68 and its processor 94 to accomplish the same algorithmically and/or coordination of electrical assembly 24 components including, but not limited to, the electric motor 62, the battery 64, and the electric distribution system 66. The memory 96 may include a single memory device or a plurality of memory devices (e.g., a computer-readable storage device that can be read, written, or otherwise accessed by a general purpose or special purpose computing device, including any processing electronics and/or processing circuitry capable of executing instructions). The present invention is not limited to any particular type of memory device, which may be non-transitory, and may include read-only memory, random access memory, volatile memory, non-volatile memory, static memory, dynamic memory, flash memory, cache memory, volatile or non-volatile semiconductor memory, optical disk storage, magnetic disk storage, magnetic tape, other magnetic storage devices, or any other medium capable of storing one or more instructions, and/or any device that stores digital information. The memory device(s) may be directly and/or indirectly coupled to the controller 68. The controller 68 may include, or may be in communication with, a user interface including one or more inputs devices and/or one or more output devices, for example, an input device that enables a user to enter data and/or instructions and an output device configured to display information (e.g., a visual display or a printer), or to transfer data, etc. Communications between the controller 68 and external electrical or electronic devices may be via a hardwire connection or via a wireless connection. A person of skill in the art will recognize that portions of the controller 68 may assume various forms (e.g., digital signal processor, analog device, etc.). In some embodiments, the propulsion system 20 may include a plurality of discrete control systems (e.g., a battery management system (BMS) controller, an electronic engine controller (EEC), a motor controller, etc.) configured to collectively perform the functions of the controller 68 described herein.

The controller 68 may form a portion of a battery management system (BMS) for the battery 64. The controller 68 may be configured to monitor conditions of the battery 64 such as, but not limited to, state of charge, state of health, temperature, etc.). The controller 68 may be connected in communication (e.g., electrical or electronic communication) with the string contactors 86 and the battery contactors 88 to control positioning of the string contactors 86 and the battery contactors 88 in their respective open conditions and closed conditions. The controller 68 may thereby control battery 64 functions such as, but not limited to, battery string 72 power distribution, thermal management, string and/or cell balancing, battery 64 charging, fault isolation, and the like. For example, the controller 68 may control the string contactors 86 and/or the battery contactors 88 to electrically isolate one or more battery strings 72 or the entire battery 64 in response to identification of an electrical fault. Examples of electrical faults include an electric arc (e.g., an arc discharge), an electrical current spike, a short circuit condition electrically downstream of the battery 64 (e.g., in the electrical distribution bus 66 or an electrical load of the electrical distribution bus 66), a high battery module 74 temperature, a fire, etc. The controller 68 may be connected in signal communication with a battery sensor assembly 98. The battery sensor assembly 98 may include sensors such as, but not limited to, voltage sensors, temperature sensors, coolant temperature and/or flow sensors, current sensors, and the like for the battery 64. The battery sensor assembly 98 may additionally include position sensors for each of the string contactors 86 and the battery contactors 88 to identify a position of the string contactors 86 and the battery contactors 88 in the open condition or the closed condition.

The controller 68 may additionally or alternatively form a portion of an electronic engine controller (EEC) for the propulsion system 20 and its engine 22. The controller 68 may control operating parameters of the engine 22 including, but not limited to, fuel flow, stator vane position (e.g., variable compressor inlet guide vane (IGV) position), compressor air bleed valve position, shaft (e.g., first shaft 50 and/or second shaft 56) torque and/or rotation speed, etc. so as to control an engine power or performance of the propulsion system 20. The controller 68 may be connected in communication (e.g., electrical or electronic communication) with the load contactors 90 to control positioning of the load contactors 90 in their respective open conditions and closed conditions. For example, the controller 68 may be connected in communication with the motor contactors 92A, 92B to energize or deenergize the electric motor 62 using the motor contactors 92A, 92B. The controller 68 may be connected in signal communication with an electrical distribution system sensor assembly 100. The electrical distribution system sensor assembly 100 may include sensors such as, but not limited to, voltage sensors, temperature sensors, current sensors, and the like for the electrical distribution system 66 and/or its electrical loads. The electrical distribution system sensor assembly 100 may additionally include position sensors for each of the load contactors 90 to identify a position of load contactors 90 in the open condition or the closed condition. In some embodiments, the controller 68 may be part of a full authority digital engine control (FADEC) system for the propulsion system 20.

During operation of the propulsion system 20 of FIG. 2, ambient air enters the propulsion system 20 through an air intake into and through a core flow path 102 of the engine 22. The ambient air flow along the core flow path 102 is compressed in the compressor section 30 and directed into the combustor 40. Fuel is injected into the combustor 40 and mixed with the compressed air to provide a fuel-air mixture. This fuel-air mixture is ignited, and combustion products thereof flow through the high-pressure turbine section 34A and the power turbine section 34B and are exhausted from the propulsion system 20. The bladed first turbine rotor 54 and the bladed second turbine rotor 58 rotationally drive the first rotational assembly 44 and the second rotational assembly 46, respectively, in response to the combustion gas flow through the high-pressure turbine section 34A and the power turbine section 34B. The second rotational assembly 46 (e.g., the second shaft 56) may drive rotation of the propulsor 26, for example, through the gear box 60. The electric motor 62 may be selectively operated (e.g., by the controller 68) to drive rotation of the propulsor 26 independently or in combination with the engine 22 through the gear box 60.

The operational life of a contactor, such as the contactors 86, 88, 90, 92, is significantly influenced by its interactions with electrical loads, particularly during switching (e.g., between an open condition and a closed condition) and interrupting electrical current. The expected operational life of a contactor may be characterized (e.g., by the manufacturer of the contactor) by a rated (e.g., predetermined) number of switching operations that the contactor may reasonably perform before failure. These rated numbers may be based on assumed voltage and current values for switching operations of the contactor. However, the operational life of a contactor is also significantly impacted by the electrical and thermal stresses experienced by the contactor at the time of the switching operation. For example, interrupting a high electrical current, especially for inductive loads, can lead to more severe arcing at the contactor, thereby accelerating erosion of contacts and increasing the risk of welding said contacts. In some instances, the operation of a contactor to break high current in the event of a fault (e.g., an electrical fault, a fire, an uncommanded acceleration fault for the electric motor 62, etc.) may conventionally necessitate prompt replacement of the contactor, due to possibility of substantial contactor degradation and wear. Accordingly, under real-use conditions, an actual number of switching operations of a contactor prior to contactor replacement or failure may deviate significantly from the rated number of switching operations for that contactor.

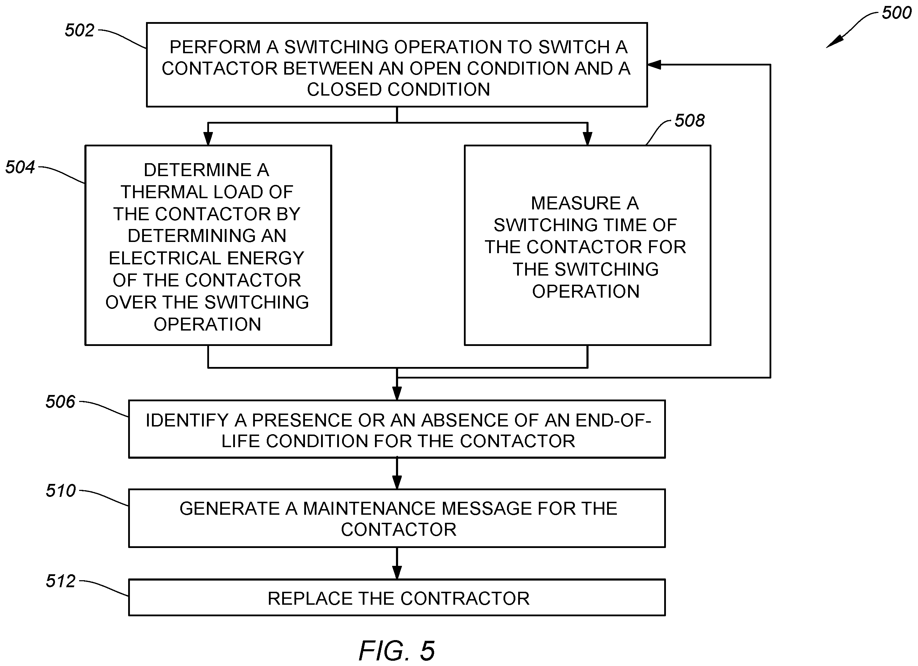

Referring to FIGS. 4 and 5, a method 500 for identifying an end-of-life condition for an electrical contactor is provided. FIG. 5 illustrates a flowchart for the method 500. The method 500 may be performed for the propulsion system 20 and its electrical assembly 24, as described herein. In particular, the method 500 will be described below for one of the contactors 84 (e.g., the contactors 86, 88, 90, 92, or another electrical contactor). The controller 68 (e.g., the processor 94) may be used to execute or control (e.g., automatically without user input) one or more steps of the method 500. For example, the processor 94 may execute instructions stored in memory 96, thereby causing the controller 68 and/or its processor 94 to execute or otherwise control one or more steps of the method 500. It should be understood, however, that the method 500 is not limited to use with the particular propulsion system 20 described herein. Unless otherwise noted herein, it should be understood that the steps of method 500 are not required to be performed in the specific sequence in which they are discussed below and, in some embodiments, the steps of method 500 may be performed separately or simultaneously.

Step 502 includes performing a switching operation to switch an operating state of the contactor 84. The switching operation includes switching the contactor 84 from the open condition to the closed condition or from the closed condition to the open condition. The switching operation may be initiated and/or controlled by the controller 68. Alternatively, the switching operation may be initiated and/or controlled by a control system discrete from the controller 68, by manual operation of the contactor 84 (e.g., a user input), or by another suitable control system.

Step 504 includes determining (e.g., with the controller 68) a thermal load experienced by the contactor 84 during the switching operation (see step 502). The thermal load may be approximated by determining an electrical energy ($EE$) experienced by the contactor 84 during the switching operation. The switching operation of the contactor 84 may be understood to occur over a period of time ($t$) between an initiation of the switching operation ($t_{initial}$) at the contactor 84 and a completion of the switching operation ($t_{final}$) at the contactor 84. Step 504 may include measuring (e.g., with the controller 68) the time ($t$) of the switching operation. The time ($t$) may be measured, for example, based on a measured changed in position of the contactor 84 (e.g., using a position sensor). The time ($t$) may alternatively be measured based on a measured change in electrical current or voltage across the contactor 84. For example, the measured time ($t$) for the switching operation from the closed condition to the open condition may be the time between an initial (e.g., steady state) current and/or voltage of the contactor 84 (e.g., a normal operating current and/or voltage for the contactor 84) and a final current and/or voltage of the contactor 84 indicative of a complete or substantially complete interruption of circuit current by the contactor 84. Alternatively, the time ($t$) may be a predetermined value for the contactor 84 (e.g., 10 milliseconds (ms), 20 ms, etc.). Determining the electrical energy ($EE$) experienced by the contactor 84 during the switching operation further includes determining (e.g., with the controller 68) the current ($I$) and the voltage ($V$) of the contactor 84 over the time ($t$). For example, step 504 may include measuring (e.g., with one of the sensor assemblies 98, 100) the current ($I$) through and/or the voltage ($V$) across the contactor 84 during the switching operation. The current ($I$) and/or the voltage ($V$) may be expressed as a function of time over the time ($t$). Alternatively, the current ($I$) and/or the voltage ($V$) may be expressed as an average of the current ($I$) and/or the voltage ($V$), respectively, over the time ($t$). The present invention is not limited to any particular form or method of calculating the current ($I$) and/or the voltage ($V$) for the time ($t$). The voltage ($V$) may alternatively be determined using predetermined initial and final voltage values (e.g., nominal operating and open circuit voltages) for the contactor 84. The electrical energy ($EE$) of the contactor 84 for the switching operation may be calculated from the following equation [1]:

$$ EE = \int_{t_{initial}}^{t_{final}} I(t)V(t)dt \qquad [1] $$

Alternatively, in some embodiments, the electrical energy (EE) of the contactor 84 may be calculated using an effective resistance (R) of the contactor 84 and without the need to determine the voltage (V). The effective resistance (R) of the contactor 84 may be a predetermined resistance value for the contactor 84. The electrical energy (EE) of the contactor 84 for the switching operation may thereby be calculated from the following equation [2]:

$$ EE = \int_{t_{initial}}^{t_{final}} I^2(t)R(t)dt \qquad [2] $$

Step 506 includes identifying an end-of-life (EOL) condition of the contactor 84 using the determined electrical energy (EE) (see step 504). In particular, the remaining operational life of the contactor 84 may be determined using the cumulative electrical energy ($EE_C$) of the contactor 84, which cumulative electrical energy ($EE_C$) includes the electrical energy (EE) determined for each switching operation of the contactor 84 over its operational life. For each switching operation of the contactor 84, the cumulative electrical energy ($EE_C$) may be incremented by the determined electrical energy (EE) for the switching operation. The controller 68 may identify a presence or an absence of the EOL condition of the contactor 84 by comparing the cumulative electrical energy ($EE_C$) to an EOL threshold for the contactor 84. A value (e.g., an electrical energy value) of the EOL threshold for the contactor 84 may be selected to include a substantial margin to likely contactor 84 failure to ensure the contactor 84 will or has a high probability of continued proper operation in the absence of the EOL condition. For example, the EOL threshold may be selected to facilitate a high probability that the contactor 84 will be capable of performing at least one worst-case fault isolation (e.g., under maximum circuit voltage and current conditions) once the cumulative electrical energy ($EE_C$) reaches the EOL threshold. The controller 68 may identify the presence of the EOL condition of the contactor 84 when the cumulative electrical energy ($EE_C$) is greater than or equal to (or otherwise exceeds) the EOL threshold. Conversely, the controller 68 may identify the absence of the EOL condition of the contactor 84 when the cumulative electrical energy ($EE_C$) is less than (or otherwise does not exceed) the EOL threshold. Routine experimentation and/or analysis may be performed by one of ordinary skill in the art to select values of the EOL threshold suitable for the particular contactor 84, the electrical system including the contactor 84, the operating conditions of the electrical system, and the safety and/or fault isolation requirements for the contactor 84, in accordance with and as informed by one or more aspects of the present invention.

In some embodiments, the method 500 may include the step 508 to further or alternatively identify the presence or the absence of the end-of-life (EOL) condition of the contactor 84 using a measured value of the time ($t$) for a switching operation of the contactor 84. As previously discussed, the method 500 (see step 504) may include measuring the time ($t$) of the switching operation for the contactor 84. As the contactor 84 wears over its operational life, the time ($t$) of switching operations for the contactor 84 may increase. For example, the time ($t$) of switching operations for the contactor 84 may increase from an initial value of 10 ms to a value of 20 ms. Of course, the present invention is not limited to the foregoing exemplary values of time ($t$). The controller 68 may identify the presence or the absence of the EOL condition of the contactor 84 by comparing the measured time ($t$) for the switching operation of the contactor 84 to a switching time threshold, which switching time threshold may be representative of an advanced wear condition of the contactor 84. In some embodiments, the controller 68 may identify the presence of the EOL condition where the cumulative electrical energy ($EE_C$) is greater than or equal to (or otherwise exceeds) the EOL threshold and the measured time ($t$) is greater than or equal to (or otherwise exceeds) the switching time threshold. The controller 68 may identify the absence of the EOL condition where the cumulative electrical energy ($EE_C$) is less than (or otherwise does not exceed) the EOL threshold or the measured time ($t$) is less than (or otherwise does not exceed) the switching time threshold. In some other embodiments, the controller 68 may identify the presence of the EOL condition where the cumulative electrical energy ($EE_C$) is greater than or equal to (or otherwise exceeds) the EOL threshold or the measured time ($t$) is greater than or equal to (or otherwise exceeds) the switching time threshold. The controller 68 may identify the absence of the EOL condition where the cumulative electrical energy ($EE_C$) is less than (or otherwise does not exceed) the EOL threshold and the measured time ($t$) is less than (or otherwise does not exceed) the switching time threshold. Routine experimentation and/or analysis may be performed by one of ordinary skill in the art to select values of the switching time threshold suitable for the particular contactor 84, the electrical system including the contactor 84, the operating conditions of the electrical system, and the safety and/or fault isolation requirements for the contactor 84, in accordance with and as informed by one or more aspects of the present invention. Moreover, the values of the switching time threshold may be different for different operations and/or conditions of the contactor 84 (e.g., switching to the open condition, switching to the closed condition, and/or for different current and/or voltage values of the contactor 84.

Step 510 may include generating (e.g., with the controller 68) a maintenance message in response to identifying the presence of the EOL condition for the contactor 84. For example, the controller 68 may generate an audible alarm, a warning light, a warning message, etc. for a pilot or for maintenance personnel of the aircraft 1000, which may be indicative to the EOL condition for the contactor 84.

Step 512 may include replacing the contactor 84 in the electrical assembly 24 in response to identification of the presence of the EOL condition for the contactor 84 and/or in response to the maintenance message (see step 510) for the contactor 84.

For aircraft propulsion systems, such as the propulsion system 20 described herein, maintaining proper functionality of electrical contactors (e.g., the contactors 84, 86, 88, 90, 92) is especially important for safety-critical systems and/or for fault isolation. However, premature replacement of contactors may unnecessarily limit propulsion system 20 operational time as well as present substantially increased maintenance costs. The present invention facilitates more accurate identification of contactor end of life conditions (e.g., by determining the thermal load experienced by the contactor during a switching operation) relative to conventional practices which may rely on only switching operation counts or measurements of contactor current to identify contactor wear, thereby promoting more reliable contactor operation while also limiting unnecessary maintenance and replacement for contactors.

While the principles of the invention have been described above in connection with specific apparatuses and methods, it is to be clearly understood that this description is made only by way of example and not as limitation on the scope of the invention. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this disclosure by way of reference). It is noted that these connections are general and, unless specified otherwise, may be direct or indirect and that this specification is not intended to be limiting in this respect. Any reference to attached, fixed, connected, or the like may include permanent, removable, temporary, partial, full and/or any other possible attachment option.

The terms "substantially," "about," "approximately," and other similar terms of approximation used throughout this patent application are intended to encompass variations or ranges that are reasonable and customary in the relevant field. These terms should be construed as allowing for variations that do not alter the basic essence or functionality of the invention. Such variations may include, but are not limited to, variations due to manufacturing tolerances, materials used, or inherent characteristics of the elements described in the claims, and should be understood as falling within the scope of the claims unless explicitly stated otherwise.

No element, component, or method step in the present invention is intended to be dedicated to the public regardless of whether the element, component, or method step is explicitly recited in the claims. As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the invention may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the invention--such as alternative materials, structures, configurations, methods, devices, and components, and so on-- may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements.

**Claims**

1. A propulsion system for an aircraft, the propulsion system comprising:

   an electrical assembly including at least one contactor and a sensor assembly, and the at least one contactor is switchable by a switching operation between an open condition and a closed condition; and
   a controller connected in signal communication with the sensor assembly, the controller includes a processor connected in signal communication with a non-transitory memory storing instructions which, when executed by the processor, cause the processor to:

   determine, using the sensor assembly, an electrical energy of the at least one contactor for each switching operation of the at least one contactor to determine a cumulative electrical energy for the at least one contactor; and
   identify a presence or an absence of an end-of-life condition for the at least one contactor by comparing the cumulative electrical energy to an end-of-life energy threshold, and the presence of the end-of-life condition is identified where the cumulative electric energy exceeds the end-of-life energy threshold.

2. The propulsion system of claim 1, wherein the instructions, when executed by the processor, further cause the processor to:

   measure a switching time of the switching operation for each switching operation of the at least one contactor; and
   identify the presence or the absence of an end-of-life condition by comparing the switching time for each switching operation to a switching time threshold, and the presence of the end-of-life condition is identified where the cumulative electric energy exceeds the end-of-life energy threshold or the switching time exceeds the switching time threshold.

3. The propulsion system of claim 1, wherein the instructions, when executed by the processor, further cause the processor to:

measure a switching time of the switching operation for each switching operation of the at least one contactor; and
identify the presence or the absence of an end-of-life condition by comparing the switching time for each switching operation to a switching time threshold, and the presence of the end-of-life condition is identified where the cumulative electric energy exceeds the end-of-life energy threshold and the switching time exceeds the switching time threshold.

4. The propulsion system of claim 2 or 3, wherein the switching time threshold has a first switching time value for the switching operation from the open condition to the closed condition, the switching time threshold has a second switching time value for the switching operation from the closed condition to the open condition, and the first switching time value is different than the second switching time value.

5. The propulsion system of any preceding claim, wherein the instructions, when executed by the processor, cause the processor to:

measure a or the switching time of the switching operation for each switching operation of the at least one contactor; and
determine the electrical energy of the at least one contactor for each switching operation of the at least one contactor using the switching time of the switching operation for each switching operation of the at least one contactor.

6. The propulsion system of any preceding claim, wherein the instructions, when executed by the processor, cause the processor to:

determine a or the switching time of the switching operation for each switching operation of the at least one contactor;
determine a current and a voltage of the at least one contactor over the switching time for each switching operation of the at least one contactor; and
determine the electrical energy of the at least one contactor for each switching operation using the switching time, the current, and the voltage.

7. The propulsion system of any of claims 1 to 5, wherein the instructions, when executed by the processor, cause the processor to:

determine a or the switching time of the switching operation for each switching operation of the at least one contactor;
determine a or the current of the at least one contactor over the switching time for each switching operation of the at least one contactor; and
determine the electrical energy of the at least one contactor for each switching operation using the switching time, the current, and a resistance of the at least one contactor.

8. The propulsion system of claim 6 or 7, wherein the switching time is a predetermined switching time value for the at least one contactor.

9. The propulsion system of any preceding claim, wherein the instructions, when executed by the processor, further cause the processor to generate a maintenance message in response to identifying the presence of the end-of-life condition for the at least one contactor.

10. A method for identifying an end-of-life condition for a contactor of an aircraft propulsion system, the method comprising:

performing at least one switching operation to switch the contactor between an open condition and a closed condition;
determining, for each switching operation of the at least one switching operation, an electrical energy of the contactor to determine a cumulative electrical energy for the contactor, the cumulative electrical energy including the electrical energy for each switching operation of the at least one switching operation; and
identifying a presence or an absence of an end-of-life condition for the contactor by comparing the cumulative electrical energy to an end-of-life energy threshold,

optionally wherein the method further comprises replacing the contactor in response to identifying the presence of the end-of-life condition for the contactor.

11. The method of claim 10, wherein the presence of the end-of-life condition is identified where the cumulative electrical energy is greater than the end-of-life energy threshold and the absence of the end-of-life condition is identified where the cumulative electrical energy is less than the end-of-life energy threshold.

12. The method of claim 10 or 11, further comprising measuring a switching time of the contactor for each of the at least one switching operation, wherein identifying the presence or the absence of the end-of-life condition for the contactor further includes comparing the switching time of the contactor for each of the at least one switching operation to a switching time threshold.

13. The method of claim 10, 11 or 12, comprising:

determining a or the switching time of the at least one switching operation for each of the at least one switching operation;

determining a current and a voltage of the contactor over the switching time for each of the at least one switching operation; and

determining the electrical energy of the contactor for each of the at least one switching operation using the switching time, the current, and the voltage,

optionally wherein the switching time is a predetermined switching time value for the contactor.

14. The method of claim 10 comprising:

determining, for each switching operation of the at least one switching operation, a switching time of the contactor between the open condition and the closed condition, wherein the electrical energy of the contactor is determined over the switching time; and

identifying a presence or an absence of an end-of-life condition for the contactor, for each of the at least one switching operations, by comparing the cumulative electrical energy to an end-of-life energy threshold and by comparing the switching time to a switching time threshold, the presence of the end-of-life condition for the contactor identified where one or both of:

the cumulative electrical energy exceeds the end-of-life energy threshold; and/or
the switching time exceeds the switching time threshold,

optionally wherein:

the switching time threshold has a first switching time value for each of the at least one switching operation from the open condition to the closed condition, the switching time threshold has a second switching time value for each of the at least switching operation from the closed condition to the open condition, and the first switching time value is different than the second switching time value; and/or

the method further comprises generating a maintenance message in response to identifying the presence of the end-of-life condition for the contactor.

15. The method of claim 14, wherein:

determining the electrical energy of the contactor over the switching time includes determining a current and a voltage of the contactor over the switching time and calculating the electrical energy using the switching time, the current, and the voltage; or

determining the electrical energy of the contactor over the switching time includes determining a current of the contactor over the switching time and calculating the electrical energy using the switching time, the current, and a resistance of the contactor.

FIG. 1

*FIG. 2*

EP 4 700 818 A1

FIG. 3

*FIG. 4*

EP 4 700 818 A1

*FIG. 5*

EP 4 700 818 A1

## EUROPEAN SEARCH REPORT

**Application Number**

EP 25 19 6842

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 415 213 A2 (PRATT & WHITNEY CANADA [CA]) 14 August 2024 (2024-08-14) * paragraphs [0026] - [0048]; figures 1-6C * | 1-15 | INV. H01H47/00 G01R31/00 G01R31/327 |
| A | US 2020/003838 A1 (ROBERTSON NICHOLAS J [US]) 2 January 2020 (2020-01-02) * paragraphs [0019] - [0037]; figures 1-5 * | 1-15 | |
| A | US 6 231 227 B1 (ANDERSEN BO L [US]) 15 May 2001 (2001-05-15) * column 4, lines 29-48; figure * | 1-15 | |
| A | US 2020/244060 A1 (HENKE REINHOLD [US] ET AL) 30 July 2020 (2020-07-30) * paragraph [0043]; figure 1 * | 1-15 | |
| A | EP 2 317 527 A1 (DELPHI TECH INC [US]) 4 May 2011 (2011-05-04) * paragraphs [0019] - [0023], [0046]; figure 4 * | 1-15 | TECHNICAL FIELDS SEARCHED (IPC) H01H B60L G01R B60V H02J B64D |

The present search report has been drawn up for all claims

| Place of search | Date of completion of the search | Examiner |
|---|---|---|
| Munich | 19 December 2025 | Ledoux, Serge |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 6842

This annex lists the patent family members relating to the patent documents cited in the above-mentioned European search report.
The members are as contained in the European Patent Office EDP file on
The European Patent Office is in no way liable for these particulars which are merely given for the purpose of information.

19-12-2025

| Patent document cited in search report | | Publication date | Patent family member(s) | | Publication date |
|---|---|---|---|---|---|
| EP 4415213 | A2 | 14-08-2024 | CA | 3228447 A1 | 15-04-2025 |
| | | | EP | 4415213 A2 | 14-08-2024 |
| | | | US | 2024332987 A1 | 03-10-2024 |
| US 2020003838 | A1 | 02-01-2020 | EP | 3588114 A2 | 01-01-2020 |
| | | | US | 2020003838 A1 | 02-01-2020 |
| US 6231227 | B1 | 15-05-2001 | EP | 1058935 A1 | 13-12-2000 |
| | | | JP | 2002533896 A | 08-10-2002 |
| | | | US | 6231227 B1 | 15-05-2001 |
| | | | US | 2001008541 A1 | 19-07-2001 |
| | | | WO | 0039823 A1 | 06-07-2000 |
| US 2020244060 | A1 | 30-07-2020 | US | 2020243268 A1 | 30-07-2020 |
| | | | US | 2020243269 A1 | 30-07-2020 |
| | | | US | 2020243275 A1 | 30-07-2020 |
| | | | US | 2020244060 A1 | 30-07-2020 |
| | | | US | 2020357580 A1 | 12-11-2020 |
| | | | US | 2020373094 A1 | 26-11-2020 |
| | | | US | 2021005401 A1 | 07-01-2021 |
| | | | US | 2021173538 A1 | 10-06-2021 |
| | | | US | 2022044882 A1 | 10-02-2022 |
| | | | US | 2022148822 A1 | 12-05-2022 |
| | | | US | 2024055195 A1 | 15-02-2024 |
| EP 2317527 | A1 | 04-05-2011 | EP | 2317527 A1 | 04-05-2011 |
| | | | EP | 2494564 A1 | 05-09-2012 |
| | | | WO | 2011051067 A1 | 05-05-2011 |

EPO FORM P0459

For more details about this annex : see Official Journal of the European Patent Office, No. 12/82